# EUROPEAN PATENT SPECIFICATION

(11) **EP 1 933 460 B1**
(45) Date of publication and mention of the grant of the patent: **20.04.2011**
(21) Application number: 06025809.2
(22) Date of filing: 13.12.2006
(51) Int. Cl.: H03J 1/00, H01P 1/213, H04B 1/12

(54) **Analogue RF device for wireless telecommunication**
Analoge Hochfrequenzvorrichtung für drahtlose Telekommunikation
Dispositif analogique à radiofréquence pour les télécommunications sans fil

(43) Date of publication of application: 18.06.2008
(73) Proprietor: Panasonic Corporation, Kadoma-shi Osaka 571-8501 (JP)
(72) Inventor: Höft, Michael, Dr., 21271 Asendorf (DE); Bartz, Olaf, 21365 Adendorf (DE); Magath, Thore, 21079 Hamburg (DE); Burger, Stefan, 21400 Reinstorf (DE); Suehiro, Yoshikazu, 24469 Halstenbek (DE)
(74) Representative: UEXKÜLL & STOLBERG

(56) References cited:
- WO-A-00/64052
- FR-A- 2 129 001
- JP-A- 1 105 601
- US-A- 4 726 071

## Description

The present invention relates to an analogue RF device for wireless telecommunication, e.g. a base station, including a transceiver, a controller, and a tunable bandpass filter panel coupled to each other to cooperate for sending and receiving telecommunication signals in a telecommunication state of operation, the tunable bandpass filter panel comprising a bandpass filter having a plurality of coupled resonators, each resonator being equipped with an adjustable frequency tuning element.

Such analogue RF devices including tunable bandpass filter panels are for example base stations for wireless telecommunication applications, mobile telecommunication devices, satellite communication and wireless internet devices, etc..

In the following description reference is made to base stations as typical example for the application of the present invention, although it should be noted that the invention is likewise applicable to other analogue RF devices including a bandpass filter panel and a transceiver.

Base stations for wireless telecommunication usually comprise an antenna, a microwave bandpass filter panel coupled to the antenna, and a transceiver coupled to the bandpass filter panel. The base station is further equipped with a controller that is coupled to the transceiver in order to allow data and signal processing for a telecommunication state of operation. The microwave bandpass filter comprises a plurality of coupled resonators which together form a bandpass filter. Each of the resonators has a resonance frequency and a quality factor (or bandwidth). In order for the filter to yield the desired filter characteristics, it is necessary to tune each of the resonators and possibly their couplings in order to achieve the desired resonance frequency and passband bandwidth, as well as a low return loss and a small passband ripple. Due to production tolerances it is necessary to tune the resonators and their couplings at the end of the production process of the filter panel.

Typically, the bandpass filter panel comprises cavity resonators, and in the following description cavity resonators are often used as examples, although it should be kept in mind that other resonator types may be used as well.

In order to allow tuning of the bandpass filter panel, the resonator cavities are equipped with adjustable frequency tuning elements, for example in the form of tuning screws which extend to the inside of the cavity and which are accessible from the outside and may be turned by a screwdriver. Further tuning screws may be provided in order to allow to adjust the coupling of adjacent resonator cavities.

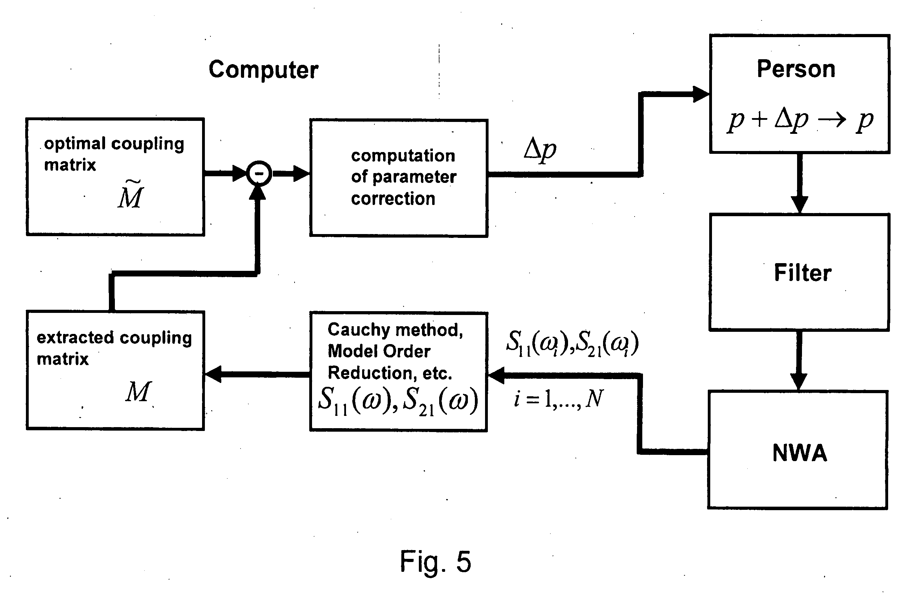

Traditionally, the tuning has been performed manually by experienced filter tuners. Figure 5 schematically shows the set-up used for tuning procedure of a filter panel in which the tuner is assisted by a computer implemented tuning algorithm. In Figure 5 the filter panel is shown as a box designated as "filter". For the purpose of filter tuning a measuring device, a so-called vector network analyser (NWA), is utilized which is connected to the filter panel and to a computer. The network analyser allows to send test signals to the filter panel and to receive scattered signals from the filter panel which allows to determine the scattering parameters, such as the return loss S11 for port 1, the return loss S22 for port 2, and the transmission S12. The network analyser normally performs a frequency sweep to determine the frequency dependence of such scattering parameters of the filter panel. The data on the frequency dependence of the scattering parameters are then used in a computer implemented algorithm to determine coupling matrices. The deviation Δp of the corresponding coupling matrices indicates the required change of resonator coupling factors and resonance frequencies which in an iterative step-by-step loop process can be manually changed by a person changing the positions of the corresponding tuning elements on the basis of the indicated required changes. In a similar manner, automated closed loop algorithms can also be applied and the operator be replaced by a robot with a single actuator which is sequentially positioned to each single tuning element. Instead of using a robot for sequentially adjusting the individual tuning elements, Miraftab et al. describe in "Automated Microwave Filter Tuning by Extracting Human Experience in Terms of Linguistic Rules Using Fuzzy Controllers", IEEE 0-7803-9542-5/06/, p. 1439-1442, a set-up using a plurality of step motors as actuators for adjusting the tuning screws of a microwave filter.

For simple filters the time domain transformed signals could be used, as reported in Hewlett-Packard Application Notes HP 1287-8A "Simplified Filter Tuning Using Time Domain" or also in Joel Dunsmore, "Tuning Band Pass Filters in the Time Domain, Digest of 1999 IEEE MTTS Int. Microwave Sym., pp. 1351-1354. In this time domain method, the filters are also measured in the frequency domain at a network analyzer, but are numerically transferred to a time domain signal. This signal basically could be interpreted as a kind of pulse response of the filter, i.e. as if a pulse is passing through the filter path of resonators and couplings. Therefore, the reflection taking place at each single resonator and coupling could be sequentially interpreted, if only one serial path is existing in the filter. This is a rather simplified approach since multiple reflections which also take place in a serial set-up are completely neglected.

Different computer aided tuning algorithms are known and many different ways of interpreting the measured scattering parameters are existing, as for example described in Ming Yu, "Robotic Computer-Aided Tuning", Microwave Journal, March 2006, pp 136-138, wherein a tuning system is presented, in which a robot is used in the production of the filter. One single actuator is position to each single tuning element, the change of the element properly interpreted. In P. Harscher and R. Vahldieck. "Automated computer-controlled tuning of waveguide filters using adaptive network models." 2001 Transactions on Microwave Theory and Techniques 49.11, Nov. 2001, pp. 2125-2130, other methods are described.

The above described automated computer-controlled tuning methods require that a vector network analyzer is available as a measuring device is coupled to the filter for the tuning. Therefore, they are only suitable for the initial tuning of the filter panel at manufacturing stage at the fabrication site.

Another aspect of relevance in connection with the present invention is that the so-called software-defined radio (SDR) is a rapidly evolving technology that is receiving widespread interest in the telecommunication industry. Over the last few years, analogue radio systems are being replaced by digital radio system for various radio applications in military, civilian and commercial areas. In addition to this, programmable hardware modules are increasingly being used in digital radio systems. The aims of SDR are to define radio functions by software, and to configure a common hardware platform for a specific air interface by downloading software during operation or as part of the production cycle. To enable users to install such technology, tunable bandpass filters are needed. These filters have to be multi-standard filters and must be tunable over wide range. Such tunable filters are for example disclosed in applicants co-pending applications EP 06015382.2 and 06015381.4.

It is an object of the present invention to design an analogue RF device for wireless tlecommunication that allows to perform a simplified tuning process, in particular without need for complicated measuring apparatus such as a vector network analyzer.

It is a further object of the present invention to provide an analogue RF device including a transceiver and a filter panel that allows re-tuning on the basis downloaded information regarding the desired filter characteristics (software defined radio).

According to the present invention an analogue RF device, e.g. a base station, for wireless telecommunication, is provided including a transceiver, a controller, and a tunable bandpass filter panel coupled to each other to cooperate to send and receive telecommunication signals in a telecommunication state of operation, the tunable bandpass filter panel comprising a bandpass filter having a plurality of coupled resonators, each resonator being equipped with an adjustable frequency tuning element, characterized in that the controller
is coupled to each adjustable tuning element to be able adjust each tuning element under its control, and is coupled to the transceiver for sending and receiving signals therethrough,
is adapted to receive and store data representative of a desired frequency dependence of at least one scattering parameter of the tunable bandpass filter,
is arranged to enter a tuning state of operation to execute an automated closed loop tuning algorithm for the tunable bandpass filter, wherein it is arranged to cause the transceiver to send test signals to the bandpass filter and to receive in response thereto, through the transceiver, scattered signals from the bandpass filter for determinig the at least one scattering parameter of the bandpass filter, such that when executing the closed loop tuning algorithm the measured at least one scattering parameter is used as input for varying the adjustments of the tuning elements in order to tune the bandpass filter to the desired frequency dependence of the at least one scattering parameter.

In such analogue RF devices, such as base stations, components like power amplifier for transmission, low noise amplifier for reception, as well as directional couplers, switches, detectors, and microcontrollers are present in the transceiver and can be utilized and operated by the controller, in a tuning state of operation, to perform measuring and tuning operations. Therefore, these components on the one hand have their conventional functions of sending, receiving and conditioning signals during the telecommunication state of operation of the device, but in addition are utilized in a tuning state of operation to send test signals to the filter panel and to perform measurements of the scattering parameters of the filter panel and to execute a tuning algorithm, without need of extra measuring apparatus as e.g. vector network analyzers. In the tuning state of operation, the controller operates the transceiver to send test signals and to receive scattered signals from the filter panel, and acquires data representing the frequency dependence of the scattering parameters. These data are used as input for a closed loop tuning algorithm which is executed by the controller. By comparing the desired frequency dependence of the scattering parameters with the measured data, the controller determines and performs modified tuning adjustments for the adjustable tuning elements, and repeats the measuring cycle for the scattering parameters. This iterative modification of the tuning element adjustments is repeated until a the deviation of the measured frequency dependence of the scattering parameters and desired frequency dependence is below a predetermined threshold.

With a proper tuning algorithm implemented in the controller and with measurement of scattering parameters of the filters inside the base station and processing of the scattering parameters by the controller and furthermore steering of the adjustable tuning elements by the controller, a closed feedback loop can be realized which is able to tune the filter according to a desired frequency dependence of the scattering parameters. Therefore, no manual tuning would be required during the production.

This present invention is also applicable wireless telecommunication devices, such as base stations, utilizing "software defined radio", in which change of the frequency band of the communication system is required, since for these applications, the filters have to be laid out to be tunable anyway.

The adjustment of the tuning elements can be performed by control of the tuning elements with help of electronically controllable actuators like e.g. stepper motors or linear piezo-motors. This allows, to individually and independently adjust each resonator of the bandpass filter panel.

Alternatively, there can be a co-ordinated adjustement of the tuning elements utilizing a movable control element, which is positioned by a drive under the control of the controller which has a cam surface. According to one embodiment (as described in co-pending application EP 06015381) such tunable bandpass filter panel has a plurality of resonator cavities, each resonator cavity being equipped with a movable frequency tuning element extending into the cavity, and a control mechanism having a movable control element, wherein the tuning elements and the control element are arranged such that an adjusting movement of the movable control element causes the tuning elements to be simultaneously displaced with respect to the resonator cavities in dependence of the adjusting movement of the control element in order to adjust the centre frequencies of the resonator cavities, wherein
each frequency tuning element comprises a cam follower which is projecting from a wall of the respective resonator cavity to the outside and which is guided for shifting movement therein to allow to adjust the frequency tuning element by sliding the cam follower further inside or outside with respect to the resonator cavity wall;
the control element comprises a cam surface with a predetermined contour, the control element and the cam followers being arranged with respect to each other such that the cam surface is in sliding contact with an outer end of each of the cam followers, wherein the control element is mounted for linear movement to vary the position of the cam surface with respect to the cam followers, and
a drive is provided to adjust the position of the control element to a desired adjusted position so that each of the cam followers and thereby its associated frequency tuning element is adjusted as determined by the contour of the cam surface.

Alternatively (as described in co-pending application EP 06015382), the tunable bandpass filter panel has a plurality of resonator cavities arranged serially along a first direction, each resonator cavity being equipped with a movable frequency tuning element extending into the cavity, and a control mechanism having a movable control element, wherein the tuning elements and the control element are arranged such that an adjusting movement of the movable control element causes the tuning elements to be simultaneously displaced within the resonator cavities in dependence of the adjusting movement of the control element in order to adjust the centre frequencies of the resonator cavities, wherein
each frequency tuning element comprises a cam follower which is projecting from a wall of the respective resonator cavity to the outside and which is guided for shifting movement therein to allow to adjust the position of frequency tuning element by sliding the cam follower further inside or outside with respect to the resonator cavity wall;
the control element comprises a cam shaft extending in the first direction and having a plurality of cam sections along its length, each cam section comprising a cam track in the form of a conical spiral and each cam section being associated with a cam follower of a frequency tuning element such that the cam follower is in sliding contact with the cam track of the associated cam section, wherein the cam shaft is mounted for rotation in such a manner that it is axially shifted along the first direction in correspondence to the slope of the conical spirals of the cam sections;
a drive is provided to rotate the cam shaft to a desired adjusted position so that each of the frequency tuning elements is adjusted by movement of its cam follower as determined by the conical spiral cam track of its associated cam section at that adjusted rotational position of the cam shaft.

However, it is preferred that the adjustment elements are individually adjstable, for example by providing a step motor or a piezo-driven actuator for each tuning element.

The operations of the controller may be performed in a single hardware unit or in several separate controlling units and microcontrollers which cooperate to establish the controller.

Embodiments of the invention will now be described in connection with an application of the invention in base stations for wireless telecommunication in connection with the accompanying drawings in which:
Figure 1 schematically shows a block diagram of a base station including a bandpass filter panel according to a first embodiment of the invention;
Figure 2 schematically shows a block diagram of a base station including a bandpass filter panel according to a second embodiment of the invention;
Figure 3 schematically shows a block diagram of a base station including a bandpass filter panel according to a third embodiment of the invention;
Figure 4 schematically shows a block diagram of a base station including a bandpass filter panel according to a fourth embodiment of the invention; and
Figure 5 schematically shows a block diagram of a conventional set-up for tuning a bandpass filter panel.

Note that in the figures only one single bandpass filter is shown, since this concept is shown for a communication system based on a switched transmit/receive communication, where transmission and reception of the signals is performed in the same frequency band (e.g. TD-SCDMA time domain switched code division multiple access). Nevertheless the same concepts are applicable to communication systems with separate transmit and receive bands, requiring separate filters.

The Figures show applications of the invention in base stations for wireless telecommunication as an example of an analogue RF device, whereas the present invention in general is applicable to various kind of telecommunication devices. In the Figures only the main components of a base station which are relevant in connection with the invention are illustrated.

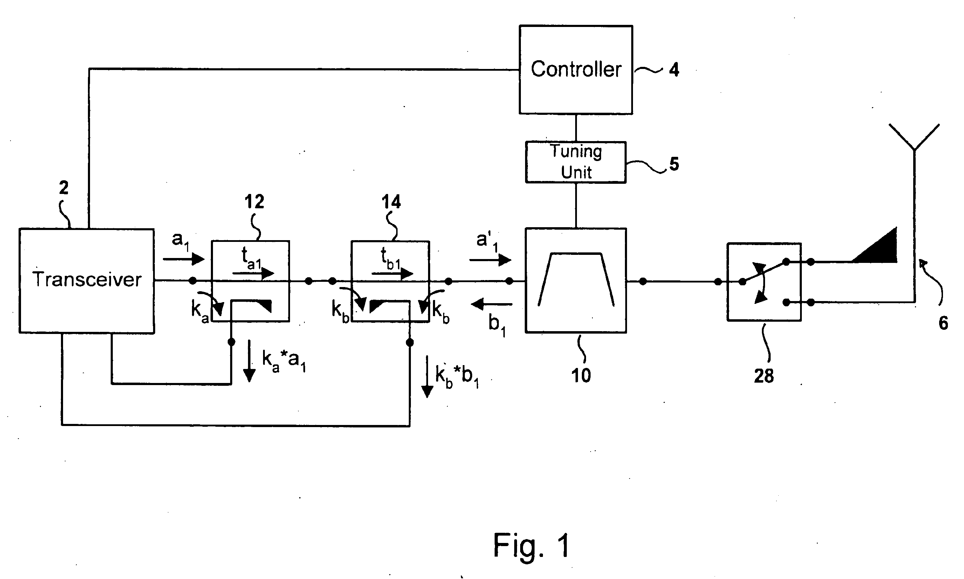

Figure 1 schematically shows a block diagram of a wireless telecommunication base station having an antenna 6 and a transceiver 2 for transmitting and receiving electromagnetic signals via the antenna 6. Between the antenna 6 and the transceiver 2 a filter panel is coupled which filters out the frequency band that is assigned to this telecommunication base station. The bandpass filter panel comprises the actual filter array 10 which is coupled to the antenna 6 via a switch 28 on the one side and which on the other side is coupled to the transceiver 2 via two couplers 12 and 14.

For executing a tuning process, a desired frequency behaviour of the filter panel which is representative of the frequency dependence of at least one scattering parameter of the filter panel is input and stored in the controller 4. The controller 4 is coupled to the transceiver 2, and can thereby control the transceiver 2 to send a test signal a₁. By means of coupler 12, a fraction kₐ x a₁ of the sent test signal a₁ is fed back to the transceiver 2. The transmitted test signal a₁' is directed to the filter panel 10 where a reflection occurs. The reflected signal b₁ is passing through a second coupler 14 where a fraction k_{b} x b₁ of the reflected signal b₁ is sent to the transceiver 2. By switching inside of the transceiver 2 the corresponding forward and reflection signals kₐ x a₁ and k_{b} x b₁ received from the couplers 12, 14 to the receiving path while the transmit path, i.e. power amplifier, is set to transmit the test signal, the scattering parameter S11 of the bandpass filter panel 10 can be determined by the controller 4. The return loss S11 can be measured as a function of the frequency by varying the frequency of the test signals sent to the bandpass filter 10.

As known from the time domain tuning method, this data would already be sufficient to determine the resonance frequencies and coupling values. Please note that also other numerical methods instead of the mentioned time domain tuning method may be applied to analyse the parameter return loss, S11.

The controller 4 is coupled to the tuning unit 5 which comprises the frequency tuning elements which are acting on the resonators in the bandpass filter panel 10. The tuning unit 5 may further comprise coupling tuning elements for adjusting the coupling strength between resonators in the bandpass filter panel 10. Only a single connecting path between the tuning unit 5 and the filter panel 10 is shown in Figure 1, whereas it should be understood that each of the plurality of frequency tuning elements in the tuning unit 5 is connected to its associated resonator, and each of the coupling tuning elements is connected to its associated coupling element. A switch 28 is coupled between the bandpass filter panel 10 and the antenna 6. This switch may likewise be controlled by the controller 4 (the coupling between controller 4 and switch 48 is not shown in Figure 1). This allows the controller 4 to couple the bandpass filter 10 and the remaining components of the device to the antenna 6 to send or receive signals in the telecommunication state of operation. In the tuning mode the bandpass filter 10 is decoupled from the antenna 6 by the switch 28 in order to avoid that a signal leaving the filter panel during the tuning mode are transmitted by the antenna 6, or that signals received by the antenna 6 are interfering with the test signal and the scattered signals. During the tuning mode the a switch 28 is switched to a state such that the filter panel is connected to a termination impedance from which no wave reflection occurs.
tₐ₁ and t_{b1} in Figure 1 designate the transmission factors of the couplers 12 and 14, respectively.

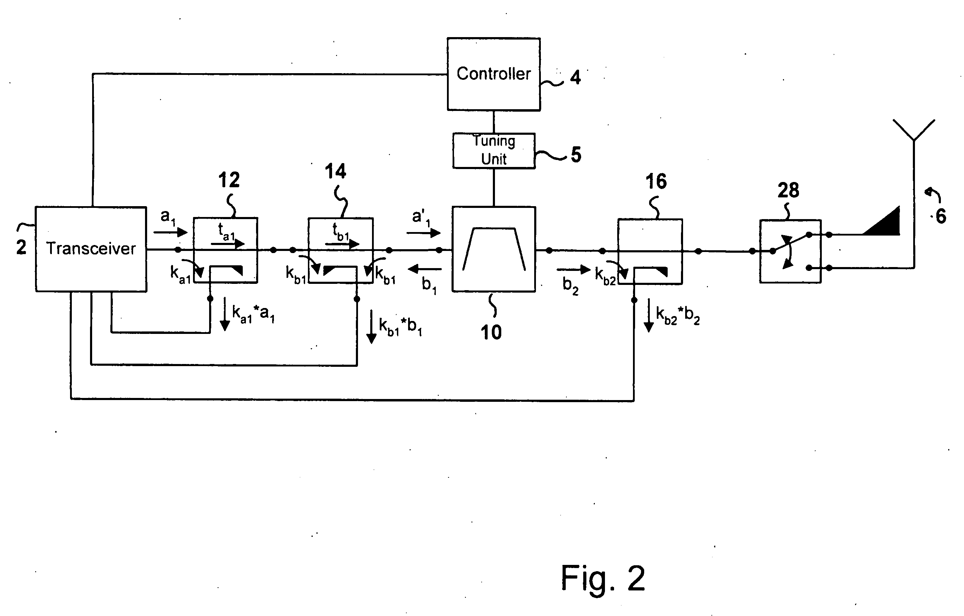

Figure 2 shows an embodiment similar to Figure 1, wherein the same components are designated by the same reference numerals. The embodiment of Figure 2 differs from the one in Figure 1 in that there is provided a further coupler 16 on the side of the filter panel 10 opposite to the first couplers 12 and 14. The signal transmitted by the bandpass filter 10, b₂, is passing through this coupler 16 and a fraction of this signal, k_{b2} x b₂ is coupled back to the transceiver 2. By the further measurement of this signal transmitted through the filter panel 10, the controller 4 is enabled to determine the transmission S21.

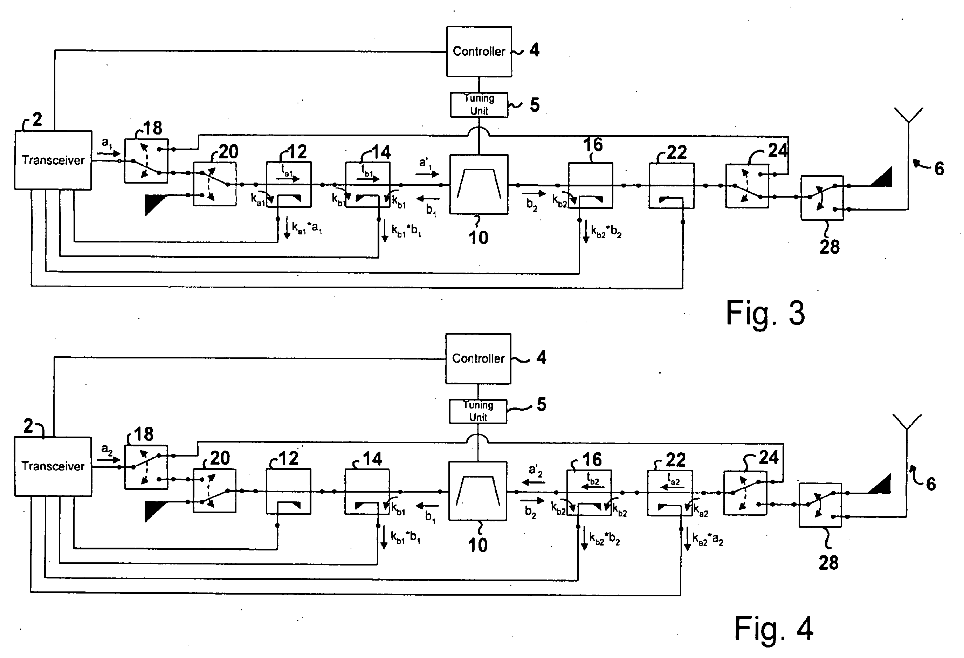

Figures 3 and 4 show a further embodiment in two different switching states. The embodiment of Figures 3 and 4 differs from the one shown in Figure 2 in that there are two further switches 18 and 20 coupled between the output side of the transceiver 2 and the first coupler 12, as well as two further switches 24 and 28 at the output side of the filter panel 10 downstream of a further coupler 22. One terminal of the switch 24 is coupled back to a terminal of the switch 18.

The switches 18, 20, 24 and 28 are controlled by controller 4 (the connecting lines between controller 4 and the respective switches 18, 20, 24 and 28 have been omitted in Figures 3 and 4 for reasons of clarity).

In the state of Figure 3 the controller may perform the same function as in the embodiment of Figure 2, i.e. a test signal a₁ is sent via coupler 12 and 14 to the filter panel 10, whereas the fraction, kₐ₁ x a₁ is coupled back to the transceiver 2, and the fraction k_{b1} x b₁ of the reflective signal b₁ is likewise coupled back to the transceiver 2. Furthermore, the signal transmitted through the panel 10 is passed through the coupler 16 and a fraction k_{b2} x b₂ is coupled back to the transceiver. By comparing the signal sent to the filter panel a₁' to the signal reflected b₁ and by comparing the transmitted signal b₂ to the input signal a₁, the scattering parameters S11 and S21 may be determined as in Figure 2.

In Figure 4 the state of the switches 18, 20 and 24 has been altered. This allows that the test signal a₂ is transferred via couplers 22 and 16 to the opposite side of the filter panel 10. After passing through the couplers 16 and 22 with known transmissions t_{b2} and tₐ₂, the through going signal a'₂ is partially transmitted as b₁ and partially reflected as b₂. A fraction of the transmitted signal b₁, namely k_{b1} x b₁ is coupled back to the receiver 2, and a portion of the reflected signal b₂ is coupled back as k_{b2} x b₂ to the transceiver 2. In this configuration it is possible to determine the returnloss S22 and the transmission S12 by comparing the amplitude of the signal sent to the filter panel to the amplitudes of the reflected and transmitted portions of this signal.

## Claims

1. An analogue RF device for wireless telecommunication, e.g. a base station, said RF device including a transceiver, a controller, and a tunable bandpass filter panel coupled to each other to cooperate for sending and receiving telecommunication signals in a telecommunication state of operation, the tunable bandpass filter panel comprising a bandpass filter having a plurality of coupled resonators, each resonator being equipped with an adjustable frequency tuning element, **characterized in that** the controller (4)
is coupled to each adjustable tuning element to be able to adjust each tuning element under its control, and is coupled.to the transceiver (2) for sending and receiving signals therethrough,
is adapted to receive and store data representative of a desired frequency dependence of at least one scattering parameter of the tunable bandpass filter (10),
is arranged to enter a tuning state of operation to execute an automated closed loop tuning algorithm for the tunable bandpass filter, wherein it is arranged to cause the transceiver (2) to send test signals to the bandpass filter (10) and to receive in response thereto, through the transceiver, scattered signals from the bandpass filter (10) for determinig the at least one scattering parameter of the bandpass filter, such that when executing the closed loop tuning algorithm the measured at least one scattering parameter is used as input for varying the adjustments of the tuning elements in order to tune the bandpass filter (10) to the desired frequency dependence of the at least one scattering parameter.

2. An analogue RF device according to claim 1, **characterized in that** at least one adjustable frequency tuning element is a varactor.

3. An analogue RF device according to claim 1, **characterized in that** the filter panel (10) comprises cavity resonators and that at least one adjustable frequency tuning element is a movable frequency tuning element extending at least partially in a cavity of its associated cavity resonator.

4. An analogue RF device according to claim 3, **characterized in that** an actuator is associated with each movable frequency tuning element, the controller being coupled to the actuator to control the positioning of the movable frequency tuning element.

5. An analogue RF device according to claim 3, **characterized in that** at least one adjustable frequency tuning element is a movable frequency tuning element extending at least partially in a cavity of its associated resonator cavity, wherein the movable frequency tuning element comprises a cam follower which is projecting from a wall of the respective resonator cavity, wherein a cam surface of a control element is in sliding contact with the outer end of the cam follower, and **in that** a drive is provided to vary the position of the cam surface with respect to the cam follower under the control of the controller.

6. An analogue RF device according to any of claims 3 to 5, wherein resonator cavities of the filter panel are coupled by coupling means which are adjustable under the control of the controller, and wherein the controller when executing the automated closed loop tuning algorithm varies the adjustments of the coupling tuning elements in the course of tuning the bandpass filter to the desired frequency dependence of the at least one scattering parameter.

7. An analogue RF device according to claim 6, wherein the coupling means are provided by coupling openings between adjacent cavity resonators, and the coupling tuning elements are movable coupling tuning elements extending into the coupling openings, wherein the positioning of the moveable coupling tuning elements in the coupling openings is adjustable under the control of the controller, and wherein the controller when executing the automated tuning algorithm varies the adjustments of the coupling tuning elements in the course of tuning the bandpass filter.

8. An analogue RF device according to claim 7, **characterized in that** each coupling tuning element is provided with an actuator to vary its position under the control of the controller.

9. An analogue RF device according to any preceeding claim, **characterized in that** in the connecting line for connecting the bandpass filter (10) to the transceiver (2) a first and a second coupler (12, 14) are provided, wherein the output ports of the first and second couplers (12, 14) are connected to the transceiver (2) to couple back a fraction of the test signal sent to and a fraction of the signal scattered back from the bandpass filter (10), repectively, in order to allow to determine the return loss (S11) as a scattering parameter.

10. An analogue RF device according to claim 9, **characterized in that** in the connecting line of the bandpass filter (10) opposite to the transceiver (2) side a third coupler (16) is provided, wherein the output port of the third coupler (16) is also connected to the transceiver (2) to couple back a fraction of the test signal transmitted through the bandpass filter (10) in order to allow to determine the transmission (S21) as a further scattering parameter.

11. An analogue RF device according to claim 10, **characterized in that** in the connecting line of the bandpass filter (10) opposite to the transceiver (2) side a fourth coupler (22) is provided, and switches (18, 24) are provided for connecting the transceiver either to the first coupler (12) or to the fourth coupler (22), wherein the output port of the fourth coupler (22) is also connected to the transceiver (2) to couple back a fraction of the test signal transmitted through the fourth coupler (22) to the bandpass filter (10), if the switches (18, 24) connect the transceiver to the fourth coupler (22), to thereby allow to determine the return loss (S22) and the transmission (S12) as scattering parameters, whereas, if the switches connect the transceiver to the first coupler (12) the scattering parameters return loss (S11) and transmission (S21) may be derived.

## Patentansprüche

1. Analoge Hochfrequenzvorrichtung für drahtlose Telekommunikation, zum Beispiel eine Basisstation, wobei die Hochfrequenzvorrichtung einen Sender-Empfänger, eine Steuereinheit und ein abstimmbares Bandpass-Filterfeld aufweist, die miteinander gekoppelt sind, um in einem Telekommunikationsbetriebszustand Telekommunikationssignale zu senden und zu empfangen, wobei das abstimmbare Bandpass-Filterfeld ein Bandpassfilter mit einer Mehrzahl von gekoppelten Resonatoren aufweist, wobei jeder Resonator mit einem einstellbaren Frequenzabstimmelement versehen ist, **dadurch gekennzeichnet, dass** die Steuereinheit (4)
mit jedem einstellbaren Abstimmelement gekoppelt ist, um in der Lage zu sein, jedes Abstimmelement unter ihrer Steuerung einzustellen, und mit dem Sender-Empfänger (2) gekoppelt ist, um durch diesen Signale zu senden und zu empfangen,
dazu angepasst ist, Daten, die für eine gewünschte Frequenzabhängigkeit wenigstens eines Streuparameters des abstimmbaren Bandpassfilters (10) repräsentativ sind, aufzunehmen und zu speichern,
dazu ausgestaltet ist, in einen Abstimmbetriebszustand einzutreten, um einen automatisierten Closed-Loop-Abstimmalgorithmus für das abstimmbare Bandpassfilter auszuführen, wobei sie dazu angepasst ist, den Sender-Empfänger (2) dazu zu veranlassen, Testsignale zu dem Bandpassfilter (10) zu senden und in Reaktion darauf von dem Bandpassfilter (10) gestreute Signale durch den Sender-Empfänger zu empfangen, um den wenigstens einen Streuparameter des Bandpassfilters zu bestimmen, so dass, wenn der Closed-Loop-Abstimmalgorithmus ausgeführt wird, der gemessene wenigstens eine Streuparameter als Eingabe zum Variieren der Einstellungen der Abstimmelemente verwendet wird, um das Bandpassfilter (10) auf die gewünschte Frequenzabhängigkeit des wenigstens einen Streuparameters abzustimmen.

2. Analoge Hochfrequenzvorrichtung nach Anspruch 1, **dadurch gekennzeichnet, dass** das wenigstens eine einstellbare Frequenzabstimmelement ein Varaktor ist.

3. Analoge Hochfrequenzvorrichtung nach Anspruch 1, **dadurch gekennzeichnet, dass** das Filterfeld (10) Hohlraumresonatoren aufweist und dass wenigstens ein einstellbares Frequenzabstimmelement ein bewegliches Frequenzabstimmelement ist, das sich wenigstens teilweise in einen Hohlraum seines zugehörigen Hohlraumresonators erstreckt.

4. Analoge Hochfrequenzvorrichtung nach Anspruch 3, **dadurch gekennzeichnet, dass** jedem beweglichen Frequenzabstimmelement ein Stellglied zugeordnet ist, wobei die Steuereinheit mit dem Stellglied verbunden ist, um die Positionierung des beweglichen Frequenzabstimmelements zu steuern.

5. Analoge Hochfrequenzvorrichtung nach Anspruch 3, **dadurch gekennzeichnet, dass** wenigstens ein einstellbares Frequenzabstimmelement ein bewegliches Frequenzabstimmelement ist, das sich wenigstens teilweise in einen Hohlraum seines zugeordneten Hohlraumresonators erstreckt, wobei das bewegliche Frequenzabstimmelement einen Steuerkurvenfolger aufweist, der von einer Wand des Hohlraumresonators vorsteht, wobei eine Steuerkurve eines Steuerelements in gleitendem Kontakt mit dem äußeren Ende des Steuerkurvenfolgers ist, und dass ein Antrieb vorgesehen ist, um die Position der Steuerkurve in Bezug auf den Steuerkurvenfolger unter der Steuerung der Steuereinheit zu variieren.

6. Analoge Hochfrequenzvorrichtung nach einem der Ansprüche 3 bis 5, wobei Hohlraumresonatoren des Filterfeldes durch Kopplungseinrichtungen gekoppelt sind, die unter der Steuerung der Steuereinheit einstellbar sind, und wobei die Steuereinheit, wenn sie den automatisierten Closed-Loop-Abstimmalgorithmus ausführt, die Einstellungen der Kopplungsabstimmelemente während des Abstimmens des Bandpassfilters auf die gewünschte Frequenzabhängigkeit des wenigstens einen Streuparameters variiert.

7. Analoge Hochfrequenzvorrichtung nach Anspruch 6, wobei die Kopplungseinrichtungen durch Kopplungsöffnungen zwischen benachbarten Hohlraumresonatoren bereitgestellt werden, und wobei die Kopplungsabstimmelemente bewegliche Kopplungsabstimmelemente sind, die in die Kopplungsöffnungen hineinreichen, wobei die Positionierung der beweglichen Kopplungsabstimmelemente in den Kopplungsöffnungen unter der Steuerung der Steuereinheit einstellbar ist, und wobei die Steuereinheit, wenn sie den automatisierten Abstimmalgorithmus ausführt, die Einstellungen der Kopplungsabstimmelemente während des Abstimmens des Bandpassfilters variiert.

8. Analoge Hochfrequenzvorrichtung nach Anspruch 7, **dadurch gekennzeichnet, dass** jedes Kopplungsabstimmelement mit einem Stellglied versehen ist, um seine Position unter der Steuerung der Steuereinheit zu variieren.

9. Analoge Hochfrequenzvorrichtung nach einem der vorhergehenden Ansprüche, **dadurch gekennzeichnet, dass** in der Verbindungsleitung zum Verbinden des Bandpassfilters (10) mit dem Sender-Empfänger (2) ein erster und ein zweiter Koppler (12, 14) vorgesehen sind, wobei die Ausgangsanschlüsse des ersten und des zweiten Kopplers (12, 14) mit Sender-Empfänger (2) verbunden sind, um einen Bruchteil des zu dem Bandpassfilter (10) gesendeten Testsignals und einen Bruchteil des davon zurückgestreuten Testsignals rückzukoppeln, um es zu ermöglichen, die Reflexionsdämpfung (S11) als einen Streuparameter zu bestimmen.

10. Analoge Hochfrequenzvorrichtung nach Anspruch 9, **dadurch gekennzeichnet, dass** in der Verbindungsleitung des Bandpassfilters (10) gegenüber der Seite des Sender-Empfängers (2) ein dritter Koppler (16) vorgesehen ist, wobei der Ausgangsanschluss des dritten Kopplers (16) ebenfalls mit dem Sender-Empfänger (2) verbunden ist, um einen Bruchteil des durch das Bandpassfilter (10) gesendeten Testsignals zurückzukoppeln, um es zu ermöglichen, die Transmission (S21) als einen weiteren Streuparameter zu bestimmen.

11. Analoge Hochfrequenzvorrichtung nach Anspruch 10, **dadurch gekennzeichnet, dass** in der Verbindungsleitung des Bandpassfilters (10) gegenüber der Seite des Sender-Empfängers (2) ein vierter Koppler (22) vorgesehen ist und das Schalter (18, 24) vorgesehen sind, um den Sender-Empfänger entweder mit dem ersten Koppler (12) oder dem vierten Koppler (22) zu verbinden, wobei der Ausgangsanschluss des vierten Kopplers (22) ebenfalls mit dem Sender-Empfänger (2) verbunden ist, um einen Bruchteil des durch den vierten Koppler (22) übertragenen Testsignals auf das Bandpassfilter (10) zurückzukoppeln, wenn die Schalter (18, 24) den Sender-Empfänger mit dem vierten Koppler (22) verbinden, um es **dadurch** zu ermöglichen, die Reflexionsdämpfung (S22) und die Transmission (S12) als Streuparameter zu bestimmen, während, wenn die Schalter den Sender-Empfänger mit dem erste Koppler (12) verbinden, die Streuparameter Reflexionsdämpfung (S11) und Transmission (S21) abgeleitet werden können.

## Revendications

1. Dispositif analogique radiofréquence pour télécommunications sans fil, par exemple une station de base, ledit dispositif radiofréquence incluant un émetteur-récepteur, un contrôleur et un panneau de filtrage passe bande accordable, couplés entre eux pour coopérer pour envoyer et recevoir des signaux de télécommunications dans un état de fonctionnement de télécommunications, le panneau de filtrage passe bande accordable comprenant un filtre passe bande ayant une pluralité de résonateurs couplés, chaque résonateur étant muni d'un élément d'accord de fréquence réglable, **caractérisé en ce que** le contrôleur (4)
est couplé à chaque élément d'accord réglable pour pouvoir régler chaque élément d'accord sous son contrôle, et est couplé- à l'émetteur-récepteur (2) pour envoyer et recevoir des signaux à travers celui-ci,
est adapté à recevoir et à mémoriser des données représentatives d'une dépendance en fréquence désirée d'au moins un paramètre de dispersion du filtre passe bande accordable (10),
est agencé pour entrer dans un état de fonctionnement d'accord pour exécuter un algorithme d'accord automatique en boucle fermée pour le filtre passe bande accordable, dans lequel il est agencé pour faire envoyer par l'émetteur-récepteur (2) des signaux d'essai au filtre passe bande (10) et pour recevoir en réponse à ceux-ci, à travers l'émetteur-récepteur, des signaux dispersés provenant du filtre passe bande (10) pour déterminer l'au moins un paramètre de dispersion du filtre passe bande, de sorte que lors de l'exécution de l'algorithme d'accord en boucle fermée, l'au moins un paramètre de dispersion mesuré est utilisé comme entrée pour faire varier les réglages des éléments d'accord pour accorder le filtre passe bande (10) à la dépendance en fréquence désirée de l'au moins un paramètre de dispersion.

2. Dispositif analogique radiofréquence selon la revendication 1, **caractérisé en ce que** l'au moins un élément d'accord de fréquence réglable est un varactor.

3. Dispositif analogique radiofréquence selon la revendication 1, **caractérisé en ce que** le panneau de filtrage (10) comprend des résonateurs à cavités et **en ce que** l'au moins un élément d'accord de fréquence réglable est un élément d'accord de fréquence mobile se prolongeant au moins partiellement dans une cavité de son résonateur à cavités associé.

4. Dispositif analogique radiofréquence selon la revendication 3, **caractérisé en ce qu'**un dispositif d'actionnement est associé à chaque élément d'accord de fréquence mobile, le contrôleur étant couplé au dispositif d'actionnement pour commander le positionnement de l'élément d'accord de fréquence mobile.

5. Dispositif analogique radiofréquence selon la revendication 3, **caractérisé en ce qu'**au moins un élément d'accord de fréquence réglable est un élément d'accord de fréquence mobile se prolongeant au moins partiellement dans une cavité de sa cavité de résonateur associée, dans lequel l'élément d'accord de fréquence mobile comprend un galet de came se projetant depuis une paroi de la cavité de résonateur respective, dans lequel une surface de came d'un élément de commande est en contact glissant avec l'extrémité extérieure du galet de came et **en ce qu'**une commande est fournie pour faire varier la position de la surface de came par rapport au galet de came sous le contrôle du contrôleur.

6. Dispositif analogique radiofréquence selon l'une quelconque des revendications 3 à 5, dans lequel les cavités de résonateur du panneau de filtrage sont couplées par des moyens de couplage qui sont réglables sous le contrôle du contrôleur, et dans lequel, lors de l'exécution de l'algorithme d'accord automatique en boucle fermée, le contrôleur fait varier les réglages des éléments d'accord de couplage pendant l'accord du filtre passe bande, à la fréquence désirée en fonction de l'au moins un paramètre de dispersion.

7. Dispositif analogique radiofréquence selon la revendication 6,dans lequel les moyens de couplage sont constitués d'ouvertures de couplage entre des résonateurs à cavités adjacents, et les éléments d'accord de couplage sont des éléments d'accord de couplage mobiles se prolongeant dans les ouvertures de couplage, dans lequel le positionnement des éléments d'accord de couplage mobiles dans les ouvertures de couplage est réglable sous le contrôle du contrôleur, et dans lequel lors de l'exécution de l'algorithme d'accord automatique, le contrôleur fait varier les réglages des éléments d'accord de couplage pendant l'accord du filtre passe bande.

8. Dispositif analogique radiofréquence selon la revendication 7, **caractérisé en ce que** chaque élément d'accord de couplage est muni d'un dispositif d'actionnement pour faire varier sa position sous le contrôle du contrôleur.

9. Dispositif analogique radiofréquence selon l'une quelconque des revendications précédentes, **caractérisé en ce que** dans la ligne de connexion pour connecter le filtre passe bande (10) à l'émetteur-récepteur (2), un premier et un deuxième coupleur (12, 14) sont prévus, dans lequel les accès de sortie des premier et deuxième coupleurs (12, 14) sont connectés à l'émetteur-récepteur (2), respectivement pour coupler en retour une fraction du signal d'essai envoyé au filtre passe bande (10) et une fraction du signal dispersé en retour du filtre passe bande (10), pour permettre de déterminer l'affaiblissement de réflexion (S11) comme paramètre de dispersion.

10. Dispositif analogique radiofréquence selon la revendication 9, **caractérisé en ce que** dans la ligne de connexion du filtre passe bande (10) opposée au côté de l'émetteur-récepteur (2), un troisième coupleur (16) est prévu, dans lequel l'accès de sortie du troisième coupleur (16) est également connecté à l'émetteur-récepteur (2) pour coupler en retour une fraction du signal d'essai transmis à travers le filtre passe bande (10) pour permettre de déterminer la transmission (S21) comme autre paramètre de dispersion.

11. Dispositif analogique radiofréquence selon la revendication 10, **caractérisé en ce que** dans la ligne de connexion du filtre passe bande (10) opposée au côté de l'émetteur-récepteur (2), un quatrième coupleur (22) est prévu, et des commutateurs (18, 24) sont prévus pour connecter l'émetteur-récepteur, soit au premier coupleur (12), soit au quatrième coupleur (22), dans lequel l'accès de sortie du quatrième coupleur (22) est également connecté à l'émetteur-récepteur (2) pour coupler en retour une fraction du signal d'essai transmis au filtre passe bande (10) à travers le quatrième coupleur (22), si les commutateurs (18, 24) connectent l'émetteur-récepteur au quatrième coupleur (22), pour permettre ainsi de déterminer l'affaiblissement de réflexion (S22) et la transmission (S21) comme paramètres de dispersion, tandis que si les commutateurs connectent l'émetteur-récepteur au premier coupleur (12), on peut déterminer comme paramètres de dispersion l'affaiblissement de réflexion (S11) et la transmission (S21).
